# EUROPEAN PATENT APPLICATION

(11) **EP 4 016 846 A1**
(43) Date of publication of application: **22.06.2022**
(21) Application number: 21196468.9
(22) Date of filing: 14.09.2021
(51) Int. Cl.: H03K 19/17736, H03K 19/1776

(54) **CIRCUITS AND METHODS FOR PROGRAMMABLE MEMORY**

(30) Priority: 21.12.2020 US 202017128773
(71) Applicant: INTEL Corporation, Santa Clara, CA 95054 (US)
(72) Inventor: Wong, Ban, Santa Clara, 95054 (US); Lowe, Wayson, Santa Clara, 95054 (US)
(74) Representative: Goddar, Heinz J.

(57) **Abstract**

An integrated circuit (100) includes a memory array circuit (101-104), flip-flop circuits (131-133, 140-155), and a write programmable matrix circuit (123). A first one of the flip-flop circuits (147) is coupled to store one of a first write address signal (WA1) or a first data input signal (DIN7). A second one of the flip-flop circuits (148) is coupled to store one of a second write address signal (WA0) or a second data input signal (DIN8). A write programmable matrix circuit (123) is coupled to receive signals stored in the flip-flop circuits. The write programmable matrix circuit is coupled to provide a subset of the signals stored in the flip-flop circuits to inputs of the memory array circuit (101-104) through option conductors in the write programmable matrix circuit during write operations to the memory array circuit.

## Description

### FIELD OF THE DISCLOSURE

The present disclosure relates to electronic circuits, and more particularly, to circuits and methods for programmable memory.

### BACKGROUND

A field programmable gate array (FPGA) is a type of integrated circuit that includes programmable interconnects and programmable logic blocks. The interconnects and logic blocks are programmable after fabrication in an FPGA. In an application specific integrated circuit (ASIC), the logic circuitry and interconnects typically have substantially less configurable features after fabrication than an FPGA. In general, an ASIC can implement a larger circuit design than an FPGA, because an ASIC is designed to use die area more efficiently, but ASIC design flow is often more expensive and complex than configuring an FPGA. A structured application specific integrated circuit (ASIC) has intermediate features between a standard ASIC and an FPGA. A structured ASIC may have the same basic logic structure as an FPGA, while being maskprogrammable instead of field-programmable, by configuring vias between metal layers in the integrated circuit. Each configuration bit in an FPGA can be replaced in a structured ASIC by either placing or not placing a via between metal contacts.

### BRIEF DESCRIPTION OF THE DRAWINGS

Figure 1 illustrates an example of a circuit block containing memory arrays that can be reconfigured for different user designs of an integrated circuit (IC), according to an embodiment.
Figure 2 illustrates an example of the memory array enable circuit of FIG. 1, according to an embodiment.
Figure 3 illustrates an example of the memory array enable circuit of FIG. 1 programmed in a configuration that enables all four of the memory array circuits, according to an embodiment.
Figure 4 illustrates an example of the memory array enable circuit of FIG. 1 programmed in another configuration that enables two of the memory array circuits, according to an embodiment.
Figure 5 illustrates an example of the memory array enable circuit of FIG. 1 programmed in another configuration that enables only one of the memory array circuits, according to an embodiment.
Figure 6 illustrates an example of the write programmable matrix circuit shown in FIG. 1, according to an embodiment.
Figure 7 illustrates an example of the read programmable matrix circuit shown in FIG. 1, according to an embodiment.
Figure 8 illustrates an example of a configuration of the write programmable matrix circuit shown in FIGS. 1 and 6, according to an embodiment.
Figure 9 illustrates an example of a configuration of the read programmable matrix circuit shown in FIGS. 1 and 7, according to an embodiment.
Figure 10 illustrates another example of a configuration of the write programmable matrix circuit shown in FIGS. 1 and 6, according to an embodiment.
Figure 11 illustrates another example of a configuration of the read programmable matrix circuit shown in FIGS. 1 and 7, according to an embodiment.
Figure 12 illustrates yet another example of a configuration of the write programmable matrix circuit shown in FIGS. 1 and 6, according to an embodiment.
Figure 13 illustrates yet another example of a configuration of the read programmable matrix circuit shown in FIGS. 1 and 7, according to an embodiment.
Figure 14 illustrates an exemplary embodiment of a structured application specific integrated circuit (ASIC) that may contain embodiments disclosed herein, for example, with respect to FIGS. 1-13.
Figure 15 illustrates examples of operations that may be performed to form a memory circuit block in an integrated circuit, according to an embodiment.

### DETAILED DESCRIPTION

Many types of integrated circuits have circuit blocks of memory arrays that are used for storing data. In some integrated circuits, one or more memory arrays are used, for example, as register files. Memory array circuit blocks may be placed in different locations in an integrated circuit (IC). User designs for FPGAs and structured ASICs may require different configurations of memory arrays. For this reason, it may be inefficient to place non-configurable memory arrays in the IC, because one or more of the non-configurable memory arrays may not be placed at the correct location for a particular user design. It would be inefficient in terms of die area usage to place each of the configurations of the memory array in every location in the IC where the memory array configurations might be used by a user design.

In some conventional FPGA and structured ASIC designs, the locations of particular memory array configurations are anticipated and placed at selected locations on the IC. However, because of inaccuracies in predicting which memory array configurations are needed at particular locations in an IC, data signals may have to be routed long distances in the IC to where the correct memory configurations are placed. This technique degrades signal performance and increases power dissipation. In some user designs, there may be an insufficient number of memory array blocks of the needed configurations in the IC. The designers of these user designs have to use a larger memory array or more memory array circuit blocks than are needed by the user designs, resulting in designs that use more power, are more costly, and have lower performance.

According to some embodiments disclosed herein, a memory circuit block can be reconfigured for different user designs of an integrated circuit (IC). The memory circuit block can be used for different purposes, for example, as a register file. Resources, such as flip-flops, in the memory circuit block can be repurposed to implement different configurations for the memory circuit block without having to place additional redundant resources in the IC, such as additional flip-flops and output drivers. The repurposed resources are strategically placed to minimize inefficiencies and large changes in timing for different reconfigurations of the memory circuit block. The memory circuit block may be placed in the IC to enable the resource repurposing without causing large variations in the interconnect loading. Because the memory circuit block can be reconfigured to satisfy the needs of different user designs for an IC, it is not necessary to anticipate the particular memory configuration that is needed in each part of the IC, if the reconfigurable memory circuit block is placed at strategic locations throughout the IC.

Various embodiments disclosed herein can enable the strategic placement of one or more circuit blocks containing memory array circuits in an integrated circuit (IC). The circuit blocks can be placed in locations in the IC that enable the reconfiguration of the memory array circuits for different configurations without requiring extra overhead. These embodiments can achieve optimized signal performance, power usage, die area, and cost. The circuit blocks can be reconfigured without performance loss. Because the circuit blocks can be reconfigured for the needs of different user designs (e.g., for an FPGA or structured ASIC), a logic circuit block in the IC is more likely to be near a memory array having the configuration needed by that logic circuit block. As a result, less interconnect resources are needed to couple the logic circuit block to the memory array, which improves performance of the memory array. Also, extra memory arrays do not need to be placed in the IC to ensure that a logic circuit block is near the memory array configuration used by that logic circuit block, which reduces IC die size and cost.

Figure (FIG.) 1 illustrates an example of a memory circuit block 100 containing memory array circuits that can be reconfigured for different user designs of an integrated circuit (IC), according to an embodiment. Memory circuit block 100 includes four memory array circuits 101-104, two global (GWL) address decoder circuits 111-112, four local (LWL) address decoder circuits 113-116, memory array enable circuit 120, four local (LWL) enable circuits 11-14, read programmable matrix circuit 122, write programmable matrix circuit 123, and flip-flop storage circuits 131-133 and 140-155. Circuit block 100 may, for example, be fabricated in an integrated circuit (IC), such as a structured application specific integrated circuit (ASIC), a standard ASIC, a programmable logic IC such as an FPGA or programmable logic device (PLD), a microprocessor or central processing unit (CPU), or a graphics processing unit (GPU).

Each of the memory array circuits 101-104 may include an array of any type of memory circuit, for example, random access memory (RAM), Flash memory, volatile or non-voltage memory, EEPROM memory, flip-flop memory, etc. Each individual memory storage circuit in memory arrays 101-104 may be, for example, a memory cell that stores one or more bits. Each of the memory array circuits 101-104 may also include input driver circuits for driving input data signals to the memory cells and output driver circuits for driving output data signals from the memory cells.

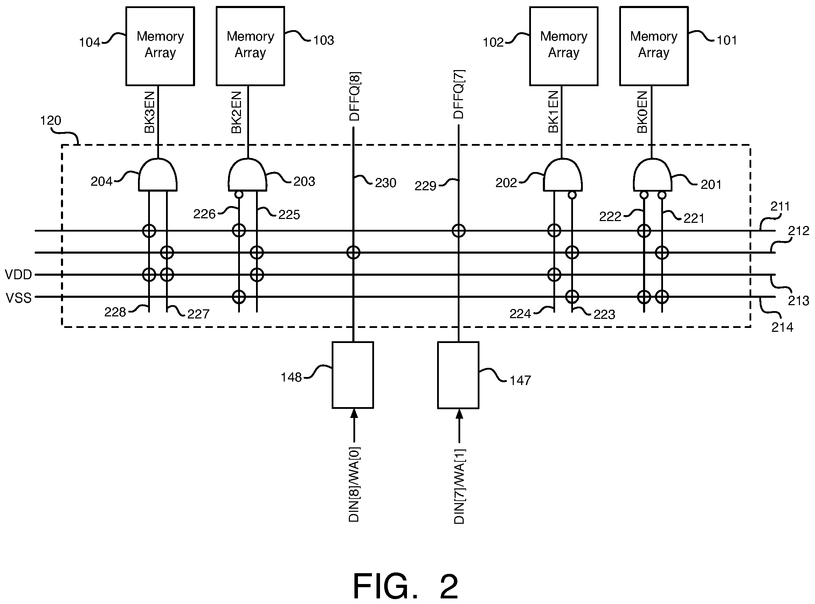

During a write operation to store data in one or more of the memory array circuits 101-104, a maximum of 16 data input signals DIN[15:0] may be provided to circuit block 100. Data input signals DIN[0]-DIN[15] are provided to inputs of flip-flop circuits 140-155, respectively, as shown in Figure (FIG.) 1. Flip-flop circuits 140-155 store the values of the data input signals DIN[15:0] as stored signals DFFQ[15:0]. Write programmable matrix circuit 123 provides the values of 4 or more of the data input signals DIN[15:0] stored in the flip-flops 140-155 to one or more of memory array circuits 101-104. Data input signals DIN[7] and DIN[8] are only provided to inputs of flip-flop circuits 147-148 during certain configurations of memory array enable circuit 120. Examples of configurations of the memory array enable circuit 120 that can receive one or both of the data input signals DIN[7] and DIN[8] are disclosed herein with respect to FIGS. 2-4.

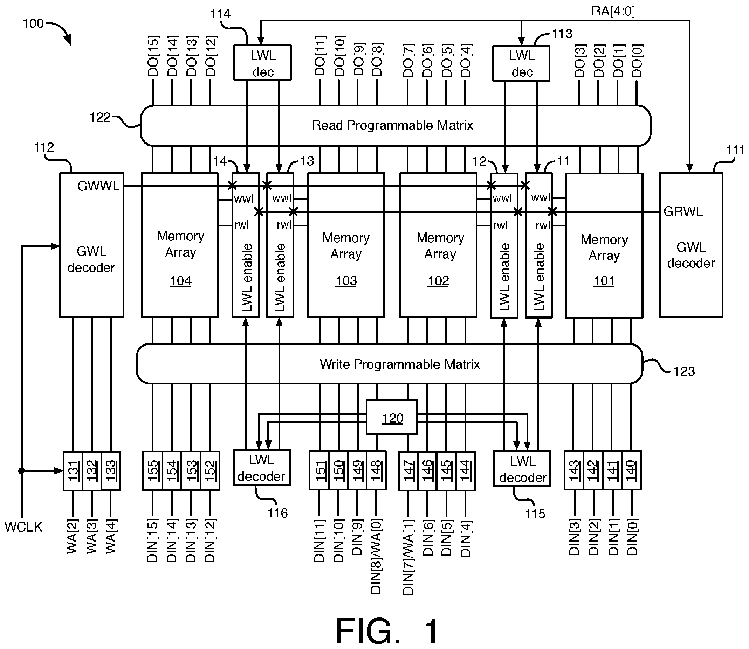

Also, during a write operation to one or more of the memory array circuits 101-104, three, four, or five write address signals WA[4:0] are provided to inputs of flip-flop circuits 148, 147, 131, 132, and 133, as shown in FIG. 1. The values of the write address signals WA[2], WA[3], and WA[4] (i.e., WA[4:2]) are stored at the outputs of flip-flop circuits 131-133, respectively, in response to a write clock signal WCLK and provided to GWL decoder circuit 112. GWL decoder circuit 112 decodes the values of the write address signals WA[4:2] to generate decoded global write address signals GWWL that are provided to inputs of LWL enable circuits 11-14, as shown in FIG. 1.

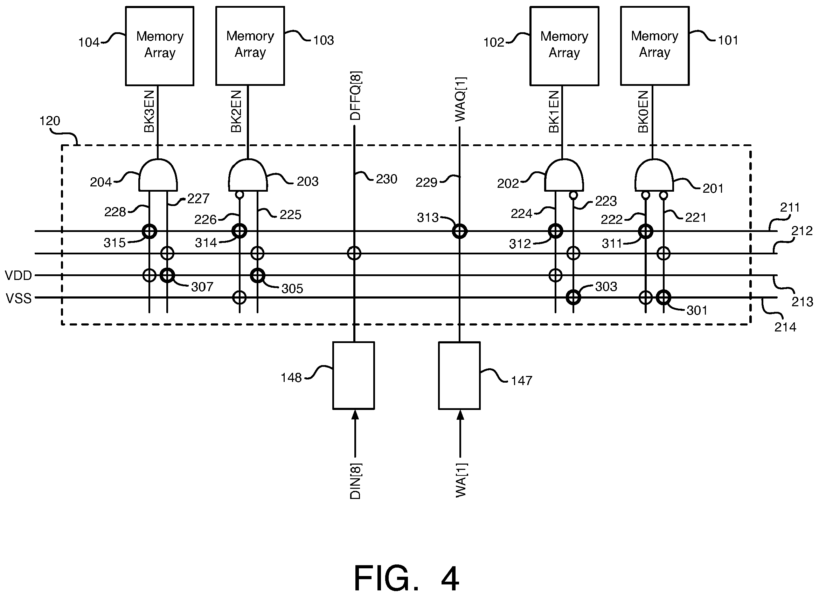

Write address signals WA[0] and WA[1] are only provided to inputs of flip-flop circuits 148 and 147, respectively, during certain configurations of memory array enable circuit 120. Examples of the memory array enable circuit 120 that are configured to receive one or both of the write address signals WA[0] and WA[1] are disclosed herein with respect to FIGS. 4-5. When enable circuit 120 is configured to receive one or both of the write address signals WA[0] and WA[1], enable circuit 120 provides the received write address signals WA[0] and WA[1] to LWL address decoder circuits 115-116. LWL address decoder circuits 115-116 decode the write address signals WA[0] and WA[1] to generate decoded local write address signals. The decoded local write address signals generated by LWL address decoder circuit 115 are provided to LWL enable circuits 11-12, and the decoded local write address signals generated by LWL decoder circuit 116 are provided to LWL enable circuits 13-14.

LWL enable circuits 11-14 generate write address signals wwl for memory arrays 101-104, respectively, based on the decoded global write address signals GWWL and based on the decoded local write address signals received from LWL decoder circuits 115-116. LWL enable circuits 11-14 provide the write address signals wwl to memory array circuits 101-104, respectively. Memory array circuits 101-104 select their memory cells having the addresses indicated by the set of write address signals wwl received from the respective LWL enable circuits 11-14. Memory array circuits 101-104 store the data indicated by the data input signals received from the write programmable matrix circuit 123 in the selected memory cells that have the addresses indicated by the set of write address signals wwl received from the respective LWL enable circuits 11-14. The write operation is then complete.

During a read operation to read data stored in one or more of the memory array circuits 101-104, 5 read address signals RA[4:0] are provided to circuit block 100. Three read address signals RA[4:2] are provided to GWL decoder circuit 111. GWL decoder circuit 111 decodes the values of the read address signals RA[4:2] to generate decoded global read address signals GRWL that are provided to inputs of LWL enable circuits 11-14. Read address signals RA[0] and RA[1] are provided to inputs of LWL address decoder circuits 114 and 113, respectively. LWL address decoder circuits 113-114 decode the read address signals RA[1] and RA[0] to generate decoded local read address signals. The decoded local read address signals generated by LWL address decoder circuit 113 are provided to LWL enable circuits 11-12, and the decoded local read address signals generated by LWL address decoder circuit 114 are provided to LWL enable circuits 13-14.

LWL enable circuits 11-14 generate read address signals rwl for memory arrays 101-104, respectively, based on the decoded global read address signals GRWL received from decoder 111 and based on the decoded local read address signals received from LWL address decoder circuits 113-114. LWL enable circuits 11-14 provide the read address signals rwl to memory array circuits 101-104, respectively. Memory array circuits 101-104 select their memory cells having the addresses indicated by the set of read address signals rwl received from the respective LWL enable circuits 11-14. Memory array circuits 101-104 read the data stored in the selected memory cells that have the addresses indicated by the set of read address signals rwl received from the respective LWL enable circuits 11-14. Memory array circuits 101-104 then output the data read from these selected memory cells to read programmable matrix circuit 122. Read programmable matrix circuit 122 then provides the data received from one or more of the memory array circuits 101-104 to outputs of memory circuit block 100 as 16 output data signals DO[15:0]. The read operation is then complete.

Figure 2 illustrates an example of the memory array enable circuit 120 of FIG. 1, according to an embodiment. In the embodiment of FIG. 2, memory array enable circuit 120 includes Boolean AND logic gate circuits 201-204, horizontal conductors 211-214, vertical conductors 221-230, and 18 programmable vias shown as circles in FIG. 2 that intersect the conductors 211-214 and 221-230. The 18 programmable vias can be programmed to connect the horizontal conductors 211-214 with the vertical conductors 221-230 at selected intersections of these conductors. In an exemplary embodiment, circuit block 100 is in a structured ASIC, and the programmable vias are programmed during fabrication of the structured ASIC by filling selected ones of the programmable vias with conductive material (e.g., metal) and not filling the remaining programmable vias with conductive material. Each of the programmable vias filled with conductive material connects one of the horizontal conductors 211-214 with one of the vertical conductors 221-230.

FIG. 2 also shows flip-flop circuits 147-148 and memory array circuits 101-104 of FIG. 1. Signals DIN[7]/WA[1] and DIN[8]/WA[0] are provided to inputs of flip-flop circuits 147-148, respectively. The values of signals DIN[7]/WA[1] and DIN[8]/WA[0] are stored in flip-flop circuits 147-148 as stored signals DFFQ[7] and DFFQ[8], respectively, in response to a clock signal. Signals DFFQ[7] and DFFQ[8] are provided to inputs of write programmable matrix 123 through conductors 229 and 230, respectively.

Two of the programmable vias in circuit 120 can be selectively programmed to couple or decouple conductors 211-212 to/from conductors 229-230. Two of the programmable vias in circuit 120 can be selectively programmed to couple or decouple conductor 221 to/from conductor 212 and conductor 214. Two of the programmable vias in circuit 120 can be selectively programmed to couple or decouple conductor 222 to/from conductor 211 and conductor 214. Two of the programmable vias in circuit 120 can be selectively programmed to couple or decouple conductor 223 to/from conductor 212 and conductor 214. Two of the programmable vias in circuit 120 can be selectively programmed to couple or decouple conductor 224 to/from conductor 211 and conductor 213. Two of the programmable vias in circuit 120 can be selectively programmed to couple or decouple conductor 225 to/from conductor 212 and conductor 213. Two of the programmable vias in circuit 120 can be selectively programmed to couple or decouple conductor 226 to/from conductor 211 and conductor 214. Two of the programmable vias in circuit 120 can be selectively programmed to couple or decouple conductor 227 to/from conductor 212 and conductor 213. Two of the programmable vias in circuit 120 can be selectively programmed to couple or decouple conductor 228 to/from conductor 211 and conductor 213.

Inverting inputs of the AND gates 201-204 are shown as circles in FIG. 2. Thus, AND gate circuit 201 has two inverting inputs, each of the AND gate circuits 202 and 203 has an inverting input and a non-inverting input, and the AND gate circuit 204 has two non-inverting inputs. The inputs of the AND logic gate circuits 201-204 are programmably coupled to receive input signal DIN[7]/WA[1], input signal DIN[8]/WA[0], a power supply voltage VDD, or a ground voltage VSS through conductors 211-214 and 221-230 and the programmable vias.

AND gate circuits 201-204 generate memory array enable signals BK0EN, BK1EN, BK2EN, and BK3EN, respectively, at their outputs by performing Boolean logic functions on their input signals. The memory array enable signals BK0EN, BK1EN, BK2EN, and BK3EN are provided through conductors in circuit block 100 to enable inputs of memory array circuits 101, 102, 103, and 104, respectively, as shown in FIG. 2. The conductors that provide the memory array enable signals from the AND gate circuits 201-204 to the memory array circuits 101-104 are not shown in FIG. 1.

The first inverting input of AND gate circuit 201 at conductor 221 may be programmably coupled to receive signal DFFQ[8] through conductor 212 or ground voltage VSS through conductor 214. The second inverting input of AND gate circuit 201 at conductor 222 may be programmably coupled to receive signal DFFQ[7] through conductor 211 or ground voltage VSS through conductor 214. The inverting input of AND gate circuit 202 at conductor 223 may be programmably coupled to receive signal DFFQ[8] through conductor 212 or ground voltage VSS through conductor 214. The non-inverting input of AND gate circuit 202 at conductor 224 may be programmably coupled to receive signal DFFQ[7] through conductor 211 or supply voltage VDD through conductor 213.

The non-inverting input of AND gate circuit 203 at conductor 225 may be programmably coupled to receive signal DFFQ[8] through conductor 212 or supply voltage VDD through conductor 213. The inverting input of AND gate circuit 203 at conductor 226 may be programmably coupled to receive signal DFFQ[7] through conductor 211 or ground voltage VSS through conductor 214. The first non-inverting input of AND gate circuit 204 at conductor 227 may be programmably coupled to receive signal DFFQ[8] through conductor 212 or supply voltage VDD through conductor 213. The second non-inverting input of AND gate circuit 204 at conductor 228 may be programmably coupled to receive signal DFFQ[7] through conductor 211 or supply voltage VDD through conductor 213.

According to various embodiments, the programmable vias in the memory array enable circuit 120 of FIG. 2 can be programmed to selectively enable or disable the memory array circuits 101-104, which allows circuit block 100 to implement different memory configurations. As specific examples, the programmable vias in memory array enable circuit 120 can be programmed to selectively enable or disable the memory array circuits 101-104 to allow circuit block 100 to function as a 32 x 8 memory array, a 16 x 8 memory array, or an 8 x 16 memory array.

As a specific example that is not intended to be limiting, 5 address bits may be used to decode 1 of 32 entries in a 32 x 8 memory array, 4 address bits may be used to decode 1 of 16 entries in a 16 x 8 memory array, and 3 address bits may be used to decode 1 of 8 entries in an 8 x 16 memory array. According to some embodiments disclosed herein, for example in FIG. 1, memory circuit block 100 containing memory array circuits 101-104 can be configured into these three different configurations by changing an address bus between 3 address lines, 4 address lines, or 5 address lines. If write operations to the memory circuit block are synchronous, the data input signals are stored in flip-flops, and the address signals are also stored in flip-flops. In the example of FIG. 1, the memory circuit block 100 includes flip-flops 131-133 and 140-155 for storing 3-5 address signals and up to 16 data signals. In this example, all 3 memory configurations can be achieved in a structured ASIC, without needing to add extra flip-flops for storing the address signals.

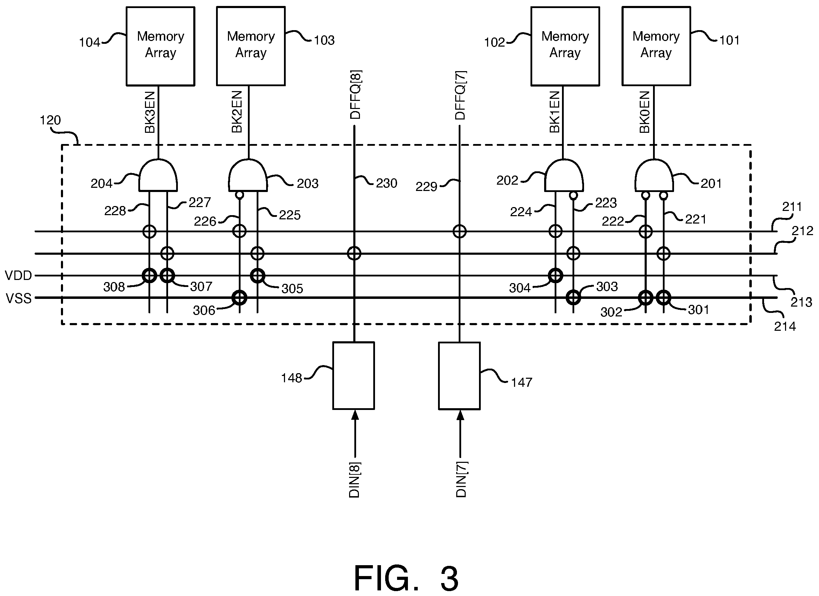

FIGS. 3-5 illustrate examples of three different configurations of the programmable vias in the memory array enable circuit 120 that selectively enable or disable different sets of the memory array circuits 101-104. As an example, one or more of the programmable vias in enable circuit 120 may be filled with conductive material (e.g., metal) during fabrication of the IC containing circuit block 100 to connect two conductors in two conductive layers that intersect above and below the respective one of the programmable vias in the top-down views of FIGS. 3-5. The programmable vias that are conductive and that connect conductors in two conductive layers are shown as bolded circles in FIGS. 3-5. The remaining programmable vias shown as non-bolded circles in FIGS. 3-5 are non-conductive, because these programmable vias are not filled with conductive material that connects intersecting conductors in different conductive layers.

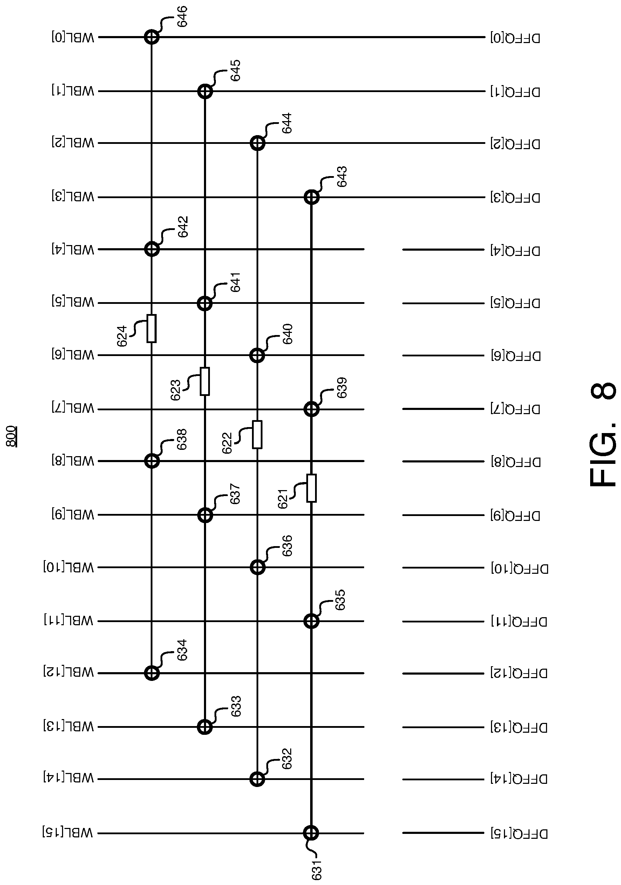

FIG. 3 illustrates an example of the memory array enable circuit 120 programmed in a configuration that enables all four of the memory array circuits 101 - 104, according to an embodiment. In the embodiment of FIG. 3, 8 of the programmable vias 301-308 in memory array enable circuit 120 are programmed to be conductive to electrically connect conductors in 2 different conductive layers. The programmable vias 301-308 may be filled with conductive material during fabrication of the IC (e.g., a structured ASIC). The non-bolded programmable vias in FIG. 3 are non-conductive and not filled with conductive material. These vias decouple the corresponding intersecting conductors.

In the embodiment of FIG. 3, signals DIN[7] and DIN[8] are provided to inputs of flip-flop circuits 147 and 148, respectively. Flip-flop circuits 147 and 148 store the logic states of signals DIN[7] and DIN[8] at their outputs as signals DFFQ[7] and DFFQ[8], respectively. Signals DFFQ[7] and DFFQ[8] are provided to inputs of write programmable matrix 123. Signals DFFQ[7] and DFFQ[8] are not provided to inputs of any of the AND gates 201-204 in FIG. 3, because conductors 229-230 are not coupled to conductors 211-212 or conductors 221-228 through programmable vias.

In the embodiment of FIG. 3, conductive vias 301-302 connect conductors 221-222, respectively, at the inverting inputs of AND gate 201 to conductor 214 at ground voltage VSS. Because conductive vias 301-302 couple the inverting inputs of AND gate 201 to ground voltage VSS in this configuration, AND gate 201 causes its output signal BK0EN to be in a logic high state. In response to enable signal BK0EN being in a logic high state, memory array circuit 101 is enabled to store data in its memory cells during a write operation, and memory array circuit 101 is enabled to read data stored in its memory cells during a read operation.

Conductive vias 303-304 connect conductors 223-224 at the inputs of AND gate 202 to conductors 214 and 213, respectively. Conductive via 303 couples the inverting input of AND gate 202 to ground voltage VSS, and conductive via 304 couples the non-inverting input of AND gate 202 to supply voltage VDD. As a result, AND gate 202 causes its output signal BK1EN to be in a logic high state. In response to enable signal BK1EN being in a logic high state, memory array circuit 102 is enabled to store data in its memory cells during a write operation, and memory array circuit 102 is enabled to read data stored in its memory cells during a read operation.

Conductive vias 305-306 connect conductors 225-226 at the inputs of AND gate 203 to conductors 213 and 214, respectively. Conductive via 305 couples the non-inverting input of AND gate 203 to supply voltage VDD, and conductive via 306 couples the inverting input of AND gate 203 to ground voltage VSS. As a result, AND gate 203 causes its output signal BK2EN to be in a logic high state. In response to enable signal BK2EN being in a logic high state, memory array circuit 103 is enabled to store data in its memory cells during a write operation, and memory array circuit 103 is enabled to read data stored in its memory cells during a read operation.

Conductive vias 307-308 connect conductors 227-228, respectively, at the inputs of AND gate 204 to conductor 213. Conductive vias 307-308 couple the non-inverting inputs of AND gate 204 to supply voltage VDD through conductor 213. As a result, AND gate 204 causes its output signal BK3EN to be in a logic high state. In response to enable signal BK3EN being in a logic high state, memory array circuit 104 is enabled to store data in its memory cells during a write operation, and memory array circuit 104 is enabled to read data stored in its memory cells during a read operation. Each of the inputs of the AND gates 201-204 is coupled to a constant voltage in FIG. 3.

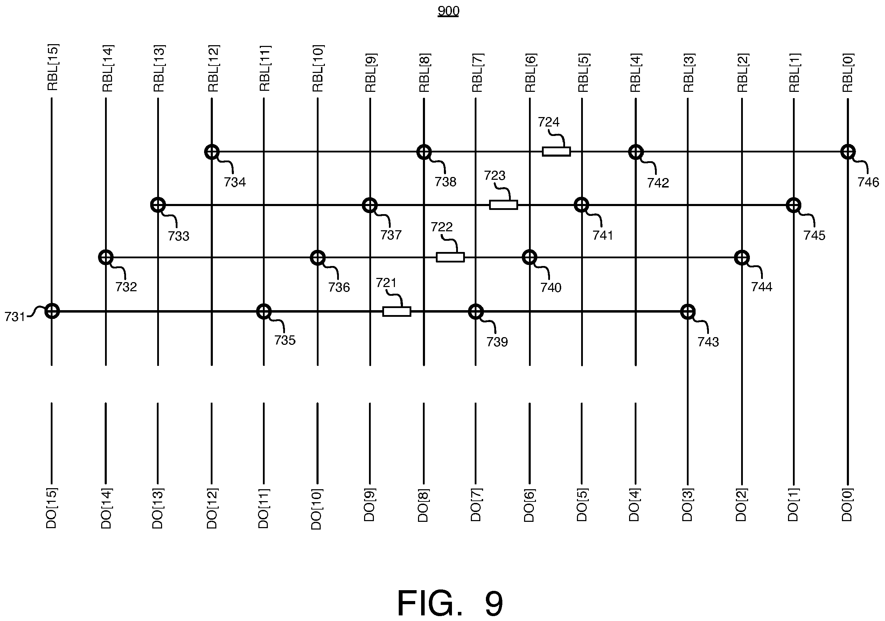

FIG. 4 illustrates an example of the memory array enable circuit 120 programmed in another configuration that enables two of the memory array circuits 101-104, according to another embodiment. In the embodiment of FIG. 4, 9 of the programmable vias 301, 303, 305, 307, and 311-315 in memory array enable circuit 120 are programmed to be conductive to electrically connect conductors in different conductive layers. The bolded programmable vias 301, 303, 305, 307, and 311-315 may be filled with conductive material during fabrication of the IC. The non-bolded programmable vias in FIG. 4 are non-conductive, including vias 302, 304, 306, and 308. As an example, these non-conductive vias may not be filled with conductive material. These non-conductive vias decouple the corresponding intersecting conductors.

In the embodiment of FIG. 4, programmable via 301 couples the first inverting input of AND gate 201 to the ground voltage VSS through conductors 221 and 214. Programmable via 303 couples the first inverting input of AND gate 202 to the ground voltage VSS through conductors 223 and 214. Programmable via 305 couples the first non-inverting input of AND gate 203 to the supply voltage VDD through conductors 225 and 213. Programmable via 307 couples the first non-inverting input of AND gate 204 to the supply voltage VDD through conductors 227 and 213. Thus, the first input of each of the AND gates 201-204 is coupled to a constant voltage.

Programmable vias 311 and 313 are programmed to couple the second inverting input of AND gate 201 to the output of flip-flop circuit 147 through conductors 222, 211, and 229. Programmable vias 312-313 are programmed to couple the second non-inverting input of AND gate 202 to the output of flip-flop circuit 147 through conductors 224, 211, and 229. Programmable vias 313-314 are programmed to couple the second inverting input of AND gate 203 to the output of flip-flop circuit 147 through conductors 226, 211, and 229. Programmable vias 313 and 315 couple the second non-inverting input of AND gate 204 to the output of flip-flop circuit 147 through conductors 228, 211, and 229.

In the embodiment of FIG. 4, signals WA[1] and DIN[8] are provided to inputs of flip-flop circuits 147 and 148, respectively. Flip-flop circuits 147 and 148 store the logic states of signals WA[1] and DIN[8] at their outputs as signals WAQ[1] and DFFQ[8], respectively. The second input of each of the AND gates 201-204 is coupled to receive the output signal WAQ[1] of flip-flop circuit 147 through conductors 229 and 211. The output signal WAQ[1] of flip-flop 147 is also provided to inputs of LWL decoder circuits 115-116 through conductor 211 as a local write address signal, in the embodiment of FIG. 4.

Because constant voltages VSS/VDD are provided to the first inputs of AND gates 201-204 as described above, the logic states of the enable signals BK0EN-BK3EN vary in response to changes in the logic state of signal WAQ[1] at the second inputs of AND gates 201-204, respectively. In response to signal WAQ[1] being in a logic high state (i.e., corresponding to a 1 bit), the AND gates 201 and 203 drive their output signals BK0EN and BK2EN to logic low states, and the AND gates 202 and 204 drive their output signals BK1EN and BK3EN to logic high states. In response to enable signals BK0EN and BK2EN being in logic low states, memory array circuits 101 and 103 are disabled and do not store or read data during write and read operations. In response to enable signals BK1EN and BK3EN being in logic high states, memory array circuits 102 and 104 are enabled to store and read data during write and read operations.

In response to signal WAQ[1] being in a logic low state (i.e., corresponding to a 0 bit), the AND gates 201 and 203 drive their output signals BK0EN and BK2EN to logic high states, and the AND gates 202 and 204 drive their output signals BK1EN and BK3EN to logic low states. In response to enable signals BK0EN and BK2EN being in logic high states, memory array circuits 101 and 103 are enabled to store and read data during write and read operations. In response to enable signals BK1EN and BK3EN being in logic low states, memory array circuits 102 and 104 are disabled and do not store or read data during write and read operations.

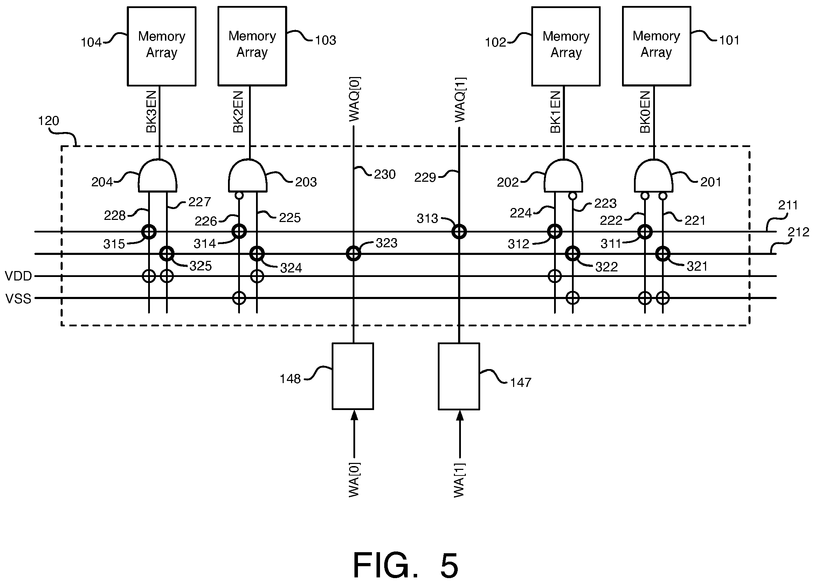

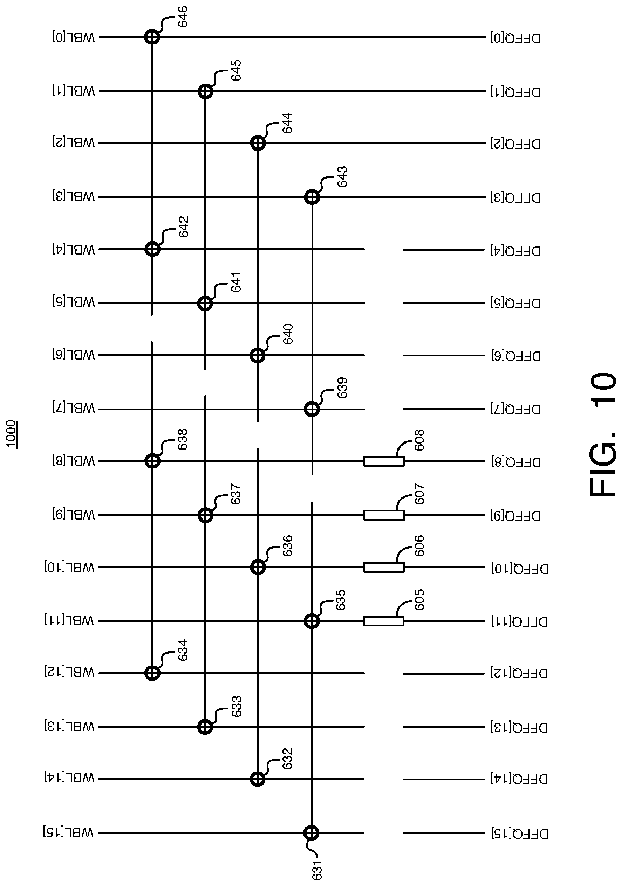

FIG. 5 illustrates an example of the memory array enable circuit 120 programmed in another configuration that enables only one of the memory array circuits 101-104, according to another embodiment. In the embodiment of FIG. 5, 10 of the programmable vias 311-315 and 321-325 in memory array enable circuit 120 are programmed to be conductive to electrically connect conductors in different conductive layers. The bolded programmable vias 311-315 and 321-325 may be filled with conductive material during fabrication of the IC. The non-bolded programmable vias in FIG. 5 are non-conductive, including vias 301-308 (e.g., are not filled with conductive material). The non-bolded vias decouple the corresponding intersecting conductors.

In the embodiment of FIG. 5, address signals WA[1] and WA[0] are provided to inputs of flip-flop circuits 147 and 148, respectively. Flip-flop circuits 147 and 148 store the logic states of signals WA[1] and WA[0] at their outputs as signals WAQ[1] and WAQ[0], respectively. The output address signals WAQ[1] and WAQ[0] are provided to inputs of LWL decoder circuits 115-116 through conductors 211-212 as local write address signals in the embodiment of FIG. 5.

The programmable vias 311-315 in FIG. 5 are programmed to connect the second inputs of the AND gates 201-204 to signal WAQ[1] generated at the output of flip-flop circuit 147 in the same configuration discussed above with respect to FIG. 4. The first input of each of the AND gates 201-204 is coupled through conductors 230 and 212 and via 323 to receive the output signal WAQ[0] of flip-flop circuit 148 in FIG. 5. More specifically, programmable vias 321 and 323 couple the first inverting input of AND gate 201 to the output of flip-flop circuit 148 through conductors 221, 212, and 230. Programmable vias 322-323 couple the first inverting input of AND gate 202 to the output of flip-flop circuit 148 through conductors 223, 212, and 230. Programmable vias 323-324 couple the first non-inverting input of AND gate 203 to the output of flip-flop circuit 148 through conductors 225, 212, and 230. Programmable vias 323 and 325 couple the first non-inverting input of AND gate 204 to the output of flip-flop circuit 148 through conductors 227, 212, and 230.

In the embodiment of FIG. 5, AND gate circuits 201-204 vary their output signals BK0EN-BK3EN in response to changes in the output signals WAQ[1] and WAQ[0] of the flip-flop circuits 147-148. In response to signals WAQ[1] and WAQ[0] both being in logic high states, the output signal BK3EN of AND gate 204 is in a logic high state, enabling write and read operations in memory array circuit 104, and the output signals BK0EN, BK1EN, and BK2EN of AND gates 201-203 are in logic low states, disabling write and read operations in memory array circuits 101-103, respectively. In response to signals WAQ[1] and WAQ[0] both being in logic low states, the output signal BK0EN of AND gate 201 is in a logic high state, enabling write and read operations in memory array circuit 101, and the output signals BK1EN, BK2EN, and BK3EN of AND gates 202-204 are in logic low states, disabling write and read operations in memory array circuits 102-104, respectively.

In response to signal WAQ[1] being in a logic high state, and signal WAQ[0] being in a logic low state, the output signal BK1EN of AND gate 202 is in a logic high state, enabling write and read operations in memory array circuit 102, and the output signals BK0EN, BK2EN, and BK3EN of AND gates 201, 203, and 204 are in logic low states, disabling write and read operations in memory array circuits 101, 103, and 104, respectively. In response to signal WAQ[1] being in a logic low state, and signal WAQ[0] being in a logic high state, the output signal BK2EN of AND gate 203 is in a logic high state, enabling write and read operations in memory array circuit 103, and the output signals BK0EN, BK1EN, and BK3EN of AND gates 201, 202, and 204 are in logic low states, disabling write and read operations in memory array circuits 101, 102, and 104, respectively. Thus, in the configuration of FIG. 5, only one of the memory array circuits 101-104 is enabled to perform write and read operations at any one time.

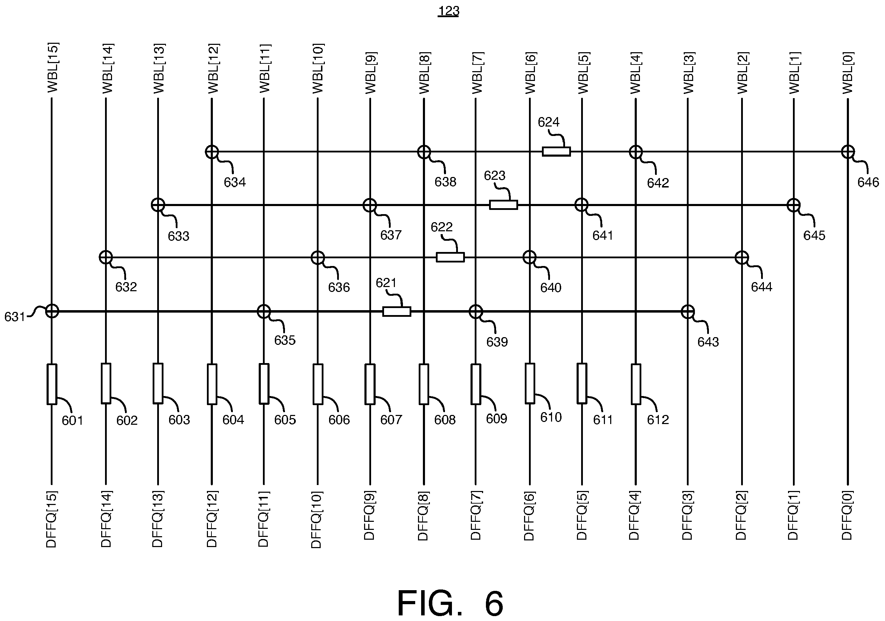

Figure 6 illustrates an example of the write programmable matrix circuit 123 shown in FIG. 1, according to an embodiment. In the embodiment of FIG. 6, the write programmable matrix 123 includes 16 option conductors 601-612 and 621-624 and 16 programmable vias 631-646. In the embodiment of FIG. 6, any of the programmable vias 631-646 may be programmed to connect two conductors in two conductive layers that intersect above and below the respective via in the top-down view of FIG. 6 by filling the via with conductive material (e.g., metal) during fabrication of the IC containing circuit block 100. Any of the programmable vias 631-646 may be programmed to be non-conductive by not filling the via with conductive material during fabrication of the IC to disconnect the intersecting conductors in the two conductive layers.

Referring to FIG. 1, flip-flop circuits 140-155 store the logic states of the data input signals DIN[0]-DIN[15] at their outputs as 16 data signals DFFQ[0]-DFFQ[15], respectively. In FIG. 6, write programmable matrix 123 receives the 16 data input signals DFFQ[0]-DFFQ[15] from the outputs of flip-flop circuits 140-155, respectively. Although in some configurations of enable circuit 120 (e.g., as shown in FIGS. 4-5), one or both of signals WAQ[1] and WAQ[0] may be provided to matrix 123 in place of signals DFFQ[7] and DFFQ[8], respectively. The write programmable matrix 123 provides 4 or more of the data input signals DFFQ[0]-DFFQ[15] as 16 data output signals WBL[0]-WBL[15] to memory array circuits 101-104 for storage during write operations. Write programmable matrix 123 provides signals WBL[0]-WBL[3] to memory array circuit 101, signals WBL[4]-WBL[7] to memory array circuit 102, signals WBL[8]-WBL[11] to memory array circuit 103, and signals WBL[12]-WBL[15] to memory array circuit 104.

The option conductors 601-612 and 621-624 are optional connections between various conductors in the write programmable matrix 123. One or more of the option conductors 601-612 and 621-624 may, for example, be formed of conductive material (e.g., metal) in a conductive layer that is deposited on the integrated circuit (IC) during fabrication of the IC and that connects adjacent conductors together. The IC may be, for example, a structured ASIC. In some embodiments, the write programmable matrix 123 is programmed during fabrication of the integrated circuit by changing the option conductors 601-612 and 621-624 to couple at least a subset of the data inputs of the write programmable matrix 123 that receive at least a subset of signals DFFQ[0]-DFFQ[15] to the data inputs of one or more of the memory array circuits 101-104. The option conductors 601-612 and 621-624 may be changed by modifying one or more masks that are used to form one or more conductive layers containing the option conductors 601-612 and 621-624. The masks are used during a photolithography process of forming the conductive layers on the integrated circuit to make selected ones of the option conductors 601-612 and 621-624 either connect or disconnect adjacent conductors. The masks may, for example, either allow conductive material to form or prevent conductive material from forming in the location of each of the option conductors 601-612 and 621-624 in the conductive layers.

Any number of the option conductors 601-612 may be formed to be conductive to connect the adjacent vertical conductors (shown as vertical lines in FIG. 6) to provide a selected number of the 12 inputs signals DFFQ[4]-DFFQ[15] as respective ones of the 12 output signals WBL[4]-WBL[15]. Any number of the option conductors 621-624 and selected ones of the vias 631-646 may be formed to be conductive to connect the adjacent horizontal conductors (shown as horizontal lines in FIG. 6) to provide the 4 input signals DFFQ[0]-DFFQ[3] as a selected 4 or more of the output signals WBL[4]-WBL[15]. One or more of the option conductors 601-612 and 621-624 may be formed as non-conductive open circuits during fabrication of the IC that disconnect adjacent conductors.

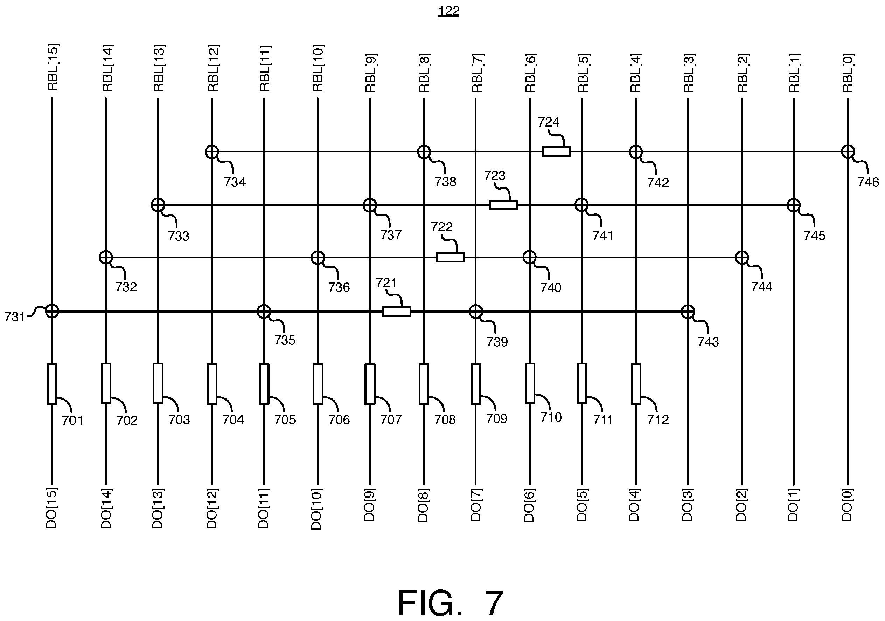

Figure 7 illustrates an example of the read programmable matrix circuit 122 shown in FIG. 1, according to an embodiment. In the embodiment of FIG. 7, the read programmable matrix 122 includes 16 option conductors 701-712 and 721-724 and 16 programmable vias 731-746. In the embodiment of FIG. 7, any of the programmable vias 731-746 may be programmed to connect two conductors in two conductive layers that intersect above and below the respective via in the top-down view of FIG. 7 by filling the via with conductive material (e.g., metal) during fabrication of the IC containing circuit block 100. One or more of the programmable vias 731-746 may be programmed to be non-conductive by not filling the respective via with conductive material during fabrication of the IC to disconnect the intersecting conductors in the conductive layers.

In FIG. 7, read programmable matrix circuit 122 receives 16 data input signals RBL[0]-RBL[15] during read operations. The 16 data signals RBL[0]-RBL[15] indicate data bits read from memory cells in memory array circuits 101-104 during read operations. Read programmable matrix circuit 122 receives signals RBL[0]-RBL[3] from memory array circuit 101, signals RBL[4]-RBL[7] from memory array circuit 102, signals RBL[8]-RBL[11] from memory array circuit 103, and signals RBL[12]-RBL[15] from memory array circuit 104. The read programmable matrix 122 provides the 16 data input signals RBL[0]-RBL[15] as 4 or more of the data output signals DO[0]-DO[15] during read operations from memory circuit bock 100.

The option conductors 701-712 and 721-724 are optional connections between various conductors in the read programmable matrix 122. One or more of the option conductors 701-712 and 721-724 may, for example, be formed of conductive material (e.g., metal) in a conductive layer that is deposited on the integrated circuit (IC) during fabrication of the IC and that connects conductors together that are adjacent to the option conductor. The IC may be, for example, a structured ASIC. In some embodiments, the read programmable matrix 122 is programmed during fabrication of the IC by changing option conductors 701-712 and 721-724 to couple the data outputs of one or more of the memory array circuits 101-104 to at least a subset of the data outputs of read programmable matrix circuit 122 that provide at least a subset of output signals DO[0]-DO[15]. The option conductors 701-712 and 721-724 may be changed by modifying one or more masks that are used to form one or more conductive layers containing the option conductors 701-712 and 721-724. The masks are used during a photolithography process of forming the conductive layers on the integrated circuit to make selected ones of the option conductors 701-712 and 721-724 either connect or disconnect adjacent conductors. The masks may, for example, either allow conductive material to form or prevent conductive material from forming in the location of each of the option conductors 701-712 and 721-724.

A selected number of the option conductors 701-712 may be formed to be conductive to connect the adjacent vertical conductors (shown as vertical lines in FIG. 7) to provide a selected number of the 12 inputs signals RBL[4]-RBL[15] as respective ones of the 12 output signals DO[4]-DO[15]. A selected number of the option conductors 721-724 and selected ones of the vias 731-746 may be formed to be conductive to connect the adjacent horizontal conductors (shown as horizontal lines in FIG. 7) to provide selected ones of the input signals RBL[4]-RBL[15] as respective ones of the output signals DO[0]-DO[3]. One or more of the option conductors 701-712 and 721-724 may be formed as non-conductive open circuits during fabrication of the IC that disconnect adjacent conductors.

Figure 8 illustrates an example of a configuration 800 of the write programmable matrix circuit 123 shown in FIGS. 1 and 6, according to an embodiment. In the configuration 800 of the write programmable matrix 123, the 12 option conductors 601-612 of FIG. 6 are non-conductive (i.e., open circuits), the 4 option conductors 621-624 of FIG. 6 are conductive (i.e., short circuits), and the 16 programmable vias 631-646 of FIG. 6 are conductive (i.e., vias filled with conductive material). Because the option conductors 601-612 are non-conductive, signals DFFQ[4]-DFFQ[15] are not provided to any of the memory array circuits 101-104 at the data outputs of configuration 800. Because the option conductors 621-624 and the programmable vias 631-646 are conductive, the 4 data input signals DFFQ[0]-DFFQ[3] are provided to the data outputs of configuration 800 as 4 output signals WBL[0]-WBL[3], as 4 output signals WBL[4]-WBL[7], as 4 output signals WBL[8]-WBL[11], and as 4 output signals WBL[12]-[15], respectively. Thus, each of the 4 data input signals DFFQ[0]-DFFQ[3] is provided as 4 of the data output signals WBL[0]-WBL[15].

In an exemplary embodiment, the configuration 800 of the write programmable matrix circuit 123 shown in FIG. 8 may be used with the configuration of the memory array enable circuit 120 shown in FIG. 5 to implement a 32-entries by 4-bit memory array (i.e., a 32 x 4 memory). In this embodiment, memory array enable circuit 120 is configurated to enable only one of the memory array circuits 101-104 to perform write operations in response to the input data signals DFFQ[0]-DFFQ[3] at any one time, as discussed in further detail with respect to FIG. 5. The logic states of the address signals WA[1] and WA[0] determine which one of the memory array circuits 101-104 is enabled to perform read and write operations and which of the 3 other memory array circuits 101-104 are disabled. When address signals WA[1] and WA[0] have logic states of 1 and 0, respectively, memory array circuit 102 is enabled, memory array circuits 101 and 103-104 are disabled, and the data bits indicated by signals DFFQ[0]-DFFQ[3] are provided to inputs of memory array circuit 102 as signals WBL[4]-WBL[7], respectively, through conductive vias 639-646. When address signals WAQ[1] and WAQ[0] both have logic states of 1, memory array circuit 104 is enabled, memory array circuits 101-103 are disabled, and the data bits indicated by signals DFFQ[0]-DFFQ[3] are provided to inputs of memory array circuit 104 as signals WBL[12]-WBL[15], respectively, through conductive vias 631-634 and 643-646 and option conductors 621-624.

When signals WAQ[1] and WAQ[0] both have logic states of 0, memory array circuit 101 is enabled, memory array circuits 102-104 are disabled, and the data bits indicated by signals DFFQ[0]-DFFQ[3] are provided to inputs of memory array circuit 101 as signals WBL[0]-WBL[3], respectively. When signals WAQ[1] and WAQ[0] have logic states of 0 and 1, respectively, memory array circuit 103 is enabled, memory array circuits 101-102 and 104 are disabled, and the data bits indicated by signals DFFQ[0]-DFFQ[3] are provided to inputs of memory array circuit 103 as signals WBL[8]-WBL[11], respectively, through conductive vias 635-638 and 643-646 and option conductors 621-624.

Figure 9 illustrates an example of a configuration 900 of the read programmable matrix circuit 122 shown in FIGS. 1 and 7, according to an embodiment. In the configuration 900 of the read programmable matrix 122, the 12 option conductors 701-712 of FIG. 7 are non-conductive (i.e., open circuits), the 4 option conductors 721-724 of FIG. 7 are conductive (i.e., short circuits), and the 16 programmable vias 731-746 of FIG. 7 are conductive (i.e., vias filled with conductive material). Because the option conductors 701-712 are non-conductive, the data outputs at DO[4]-DO[15] do not receive data output signals from any of the memory array circuits 101-104 in configuration 900. Because the option conductors 721-724 and the programmable vias 731-746 are conductive, the data outputs at DO [0]-DO [3] are coupled to receive either the 4 output signals RBL[0]-RBL[3], the 4 output signals RBL[4]-RBL[7], the 4 output signals RBL[8]-RBL[11], or the 4 output signals RBL[12]-RBL[15], respectively, at any one time.

In an exemplary embodiment, the configuration 900 of the read programmable matrix circuit 122 shown in FIG. 9 may be used with the configuration of the memory array enable circuit 120 shown in FIG. 5 and the configuration 800 of the write programable matrix 123 shown in FIG. 8 to implement a 32-entries by 4-bit memory array (i.e., a 32 x 4 memory) using memory array circuits 101-104. In this embodiment, memory array enable circuit 120 is configurated to enable only one of the memory array circuits 101-104 to perform read operations at any one time, as discussed in further detail with respect to FIG. 5. The logic states of the write address signals WA[1] and WA[0] determine which one of the memory array circuits 101-104 is enabled to perform read and write operations and which of the 3 other memory array circuits 101-104 are disabled. When address signals WA[1] and WA[0] have logic states of 1 and 0, respectively, memory array circuit 102 is enabled, memory array circuits 101 and 103-104 are disabled, and the data bits indicated by signals RBL[4]-RBL[7] are provided to the data outputs of circuit block 100 as signals DO[0]-DO[3], respectively, through conductive vias 739-746. When address signals WAQ[1] and WAQ[0] both have logic states of 1, memory array circuit 104 is enabled, memory array circuits 101-103 are disabled, and the data bits indicated by signals RBL[12]-RBL[15] are provided to data outputs of circuit block 100 as signals DO[0]-DO[3], respectively, through conductive vias 731-734 and 743-746 and option conductors 721-724.

When signals WAQ[1] and WAQ[0] both have logic states of 0, memory array circuit 101 is enabled, memory array circuits 102-104 are disabled, and the data bits indicated by signals RBL[0]-RBL[3] are provided to data outputs of circuit block 100 as signals DO[0]-DO[3], respectively. When signals WAQ[1] and WAQ[0] have logic states of 0 and 1, respectively, memory array circuit 103 is enabled, memory array circuits 101-102 and 104 are disabled, and the data bits indicated by signals RBL[8]-RBL[11] are provided to data outputs of circuit block 100 as signals DO[0]-DO[3], respectively, through conductive vias 735-738 and 743-746 and option conductors 721-724.

Figure 10 illustrates an example of a configuration 1000 of the write programmable matrix circuit 123 shown in FIGS. 1 and 6, according to another embodiment. In the configuration 1000 of write programmable matrix 123, the 12 option conductors 601-604, 609-612, and 621-624 of FIG. 6 are non-conductive (i.e., open circuits), the 4 option conductors 605-608 of FIG. 6 are conductive (i.e., short circuits), and the 16 programmable vias 631-646 of FIG. 6 are conductive (i.e., vias filled with conductive material). Because option conductors 601-604, 609-612, and 621-624 are non-conductive, signals DFFQ[4]-DFFQ[7] and DFFQ[12]-DFFQ[15] are not provided to any of the data outputs of configuration 1000. The 4 input signals DFFQ[0]-DFFQ[3] are provided to 8 data outputs of configuration 1000 as 4 output signals WBL[0]-WBL[3] and as 4 output signals WBL[4]-WBL[7], respectively. Thus, each of the input signals DFFQ[0]-DFFQ[3] is provided as 2 of the output signals WBL[0]-WBL[7]. The 4 input signals DFFQ[8]-DFFQ[11] are provided to 8 data outputs of configuration 1000 as 4 output signals WBL[8]-WBL[11] and as 4 output signals WBL[12]-WBL[15], respectively. Thus, each of the input signals DFFQ[8]-DFFQ[11] is provided as 2 of the output signals WBL[8]-WBL[15].

In an exemplary embodiment, the configuration 1000 of the write programmable matrix circuit 123 shown in FIG. 10 may be used with the configuration of the memory array enable circuit 120 shown in FIG. 4 to implement a 16-entries by 8-bit memory (i.e., a 16 x 8 memory). In this embodiment, memory array enable circuit 120 is configurated to enable only 2 of the memory array circuits 101-104 to perform write operations in response to the input signals DFFQ[0]-DFFQ[3] and DFFQ[8]-DFFQ[11] at any one time, as discussed in further detail with respect to FIG. 4. The logic state of the address signal WA[1] determines which 2 of the memory array circuits 101-104 are enabled to perform read and write operations and which 2 of the memory array circuits 101-104 are disabled.

Referring to configuration 1000, when address signal WA[1] has a logic state of 1, memory array circuits 101 and 103 are disabled, memory array circuits 102 and 104 are enabled, the data bits indicated by signals DFFQ[0]-DFFQ[3] are provided to data inputs of memory array circuit 102 as signals WBL[4]-WBL[7], respectively, through conductive vias 639-646, and the data bits indicated by signals DFFQ[8]-DFFQ[11] are provided to data inputs of memory array circuit 104 as signals WBL[12]-WBL[15], respectively, through conductive vias 631-638. When signal WA[1] has a logic state of 0, memory array circuits 102 and 104 are disabled, memory array circuits 101 and 103 are enabled, the data bits indicated by signals DFFQ[0]-DFFQ[3] are provided to data inputs of memory array circuit 101 as signals WBL[0]-WBL[3], respectively, and the data bits indicated by signals DFFQ[8]-DFFQ[11] are provided to inputs of memory array circuit 103 as signals WBL[8]-WBL[11] through option conductors 605-608, respectively.

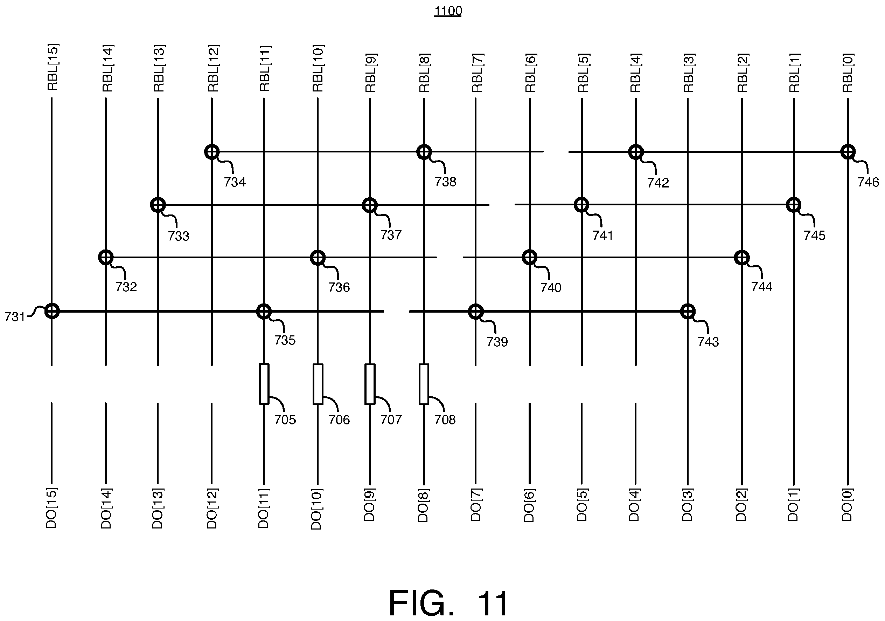

Figure 11 illustrates an example of a configuration 1100 of the read programmable matrix circuit 122 shown in FIGS. 1 and 7, according to an embodiment. In the configuration 1100 of read programmable matrix 122, the 12 option conductors 701-704, 709-712, and 721-724 of FIG. 7 are non-conductive (i.e., open circuits), the 4 option conductors 705-708 are conductive, and the 16 programmable vias 731-746 of FIG. 7 are conductive (i.e., vias filled with conductive material). Because the option conductors 701-704 and 709-712 are non-conductive, the data outputs atDO[4]-DO[7] and DO[12]-DO[15] do not receive data output signals from any of the memory array circuits 101-104 in configuration 1100. Also, in configuration 1100, the data outputs at DO[0]-DO[3] are coupled to receive either the 4 output signals RBL[0]-RBL[3] or the 4 output signals RBL[4]-RBL[7], respectively, at any one time. Also, in configuration 1100, the data outputs at DO[8]-DO[11] are coupled to receive either the 4 output signals RBL[8]-RBL[11] or the 4 output signals RBL[12]-RBL[15], respectively, at any one time.

In an exemplary embodiment, the configuration 1100 of the read programmable matrix circuit 122 shown in FIG. 11 may be used with the configuration of the memory array enable circuit 120 shown in FIG. 4 and the configuration 1000 of the write programable matrix 123 shown in FIG. 10 to implement a 16-entries by 8-bit memory (i.e., a 16 x 8 memory). In this embodiment, memory array enable circuit 120 is configurated to enable only 2 of the memory array circuits 101-104 to perform read and write operations, as described in further detail with respect to FIG. 4. The logic state of address signal WA[1] determines which 2 of the memory array circuits 101-104 are enabled to perform read and write operations and which 2 of the memory array circuits 101-104 are disabled.

Referring to configuration 1100, when address signal WA[1] has a logic state of 1, memory array circuits 101 and 103 are disabled, memory array circuits 102 and 104 are enabled, the data bits indicated by signals RBL[4]-RBL[7] are provided to data outputs of matrix 122 as signals DO[0]-DO[3], respectively, through conductive vias 739-746, and the data bits indicated by signals RBL[12]-RBL[15] are provided to data outputs of matrix 122 as signals DO[8]-DO[11], respectively, through conductive vias 731-738 and option conductors 705-708. When address signal WA[1] has a logic state of 0, memory array circuits 101 and 103 are enabled, memory array circuits 102 and 104 are disabled, the data bits indicated by signals RBL[0]-RBL[3] are provided to data outputs of matrix 122 as signals DO[0]-DO[3], respectively, and the data bits indicated by signals RBL[8]-RBL[11] are provided to data outputs of matrix 122 as signals DO[8]-DO[11] through option conductors 708, 707, 706, and 705, respectively.

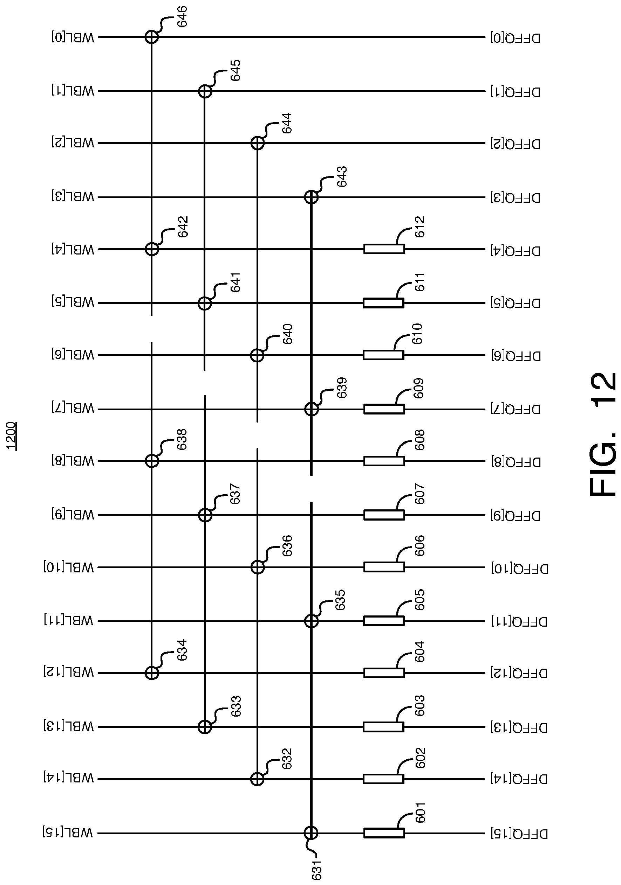

Figure 12 illustrates an example of a configuration 1200 of the write programmable matrix circuit 123 shown in FIGS. 1 and 6, according to an embodiment. In the configuration 1200 of the write programmable matrix 123, the 4 option conductors 621-624 of FIG. 6 are non-conductive (i.e., open circuits), the 12 option conductors 601-612 of FIG. 6 are conductive (i.e., short circuits), and the 16 programmable vias 631-646 of FIG. 6 are non-conductive (i.e., not filled with conductive material). In configuration 1200, the 16 data input signals DFFQ[0]-DFFQ[15] are provided to the 16 data outputs of matrix 123 as the 16 data output signals WBL[0]-WBL[15], respectively. Data input signals DFFQ[15]-DFFQ[4] are provided through option conductors 601-612 as data output signals WBL[15]-WBL[4], respectively. In an exemplary embodiment, the configuration 1200 of write programmable matrix circuit 123 shown in FIG. 12 may be used with the configuration of memory array enable circuit 120 shown in FIG. 3 to implement an 8-entries by 16-bit memory (i.e., an 8 x 16 memory). In this embodiment, memory array enable circuit 120 is configurated to enable all 4 of the memory array circuits 101-104 to perform write operations in response to the input signals DFFQ[0]-DFFQ[15], as discussed in further detail with respect to FIG. 3.

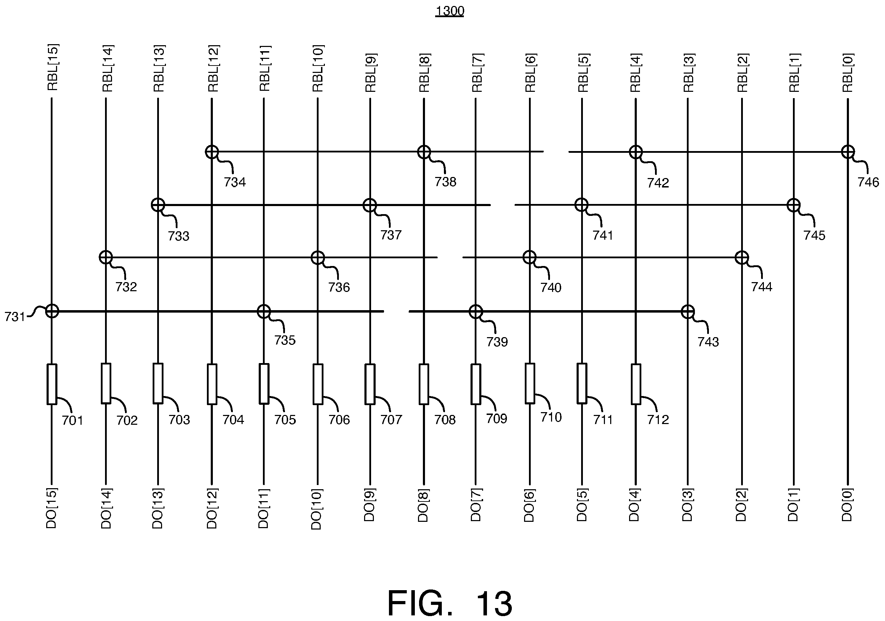

Figure 13 illustrates an example of a configuration 1300 of the read programmable matrix circuit 122 shown in FIGS. 1 and 7, according to an embodiment. In the configuration 1300 of read programmable matrix 122, the 4 option conductors 721-724 of FIG. 7 are non-conductive (i.e., open circuits), the 12 option conductors 701-712 are conductive, and the 16 programmable vias 731-746 of FIG. 7 are non-conductive (i.e., not filled with conductive material). In configuration 1300, the 16 data output signals RBL[0]-RBL[15] of the memory array circuits 101-104 are provided to the 16 data outputs of matrix 122 as the 16 data output signals DO[0]-DO[15], respectively. Data signals RBL[15]-RBL[4] are provided through option conductors 701-712 as data output signals DO[15]-DO[4], respectively. In an exemplary embodiment, the configuration 1300 of read programmable matrix circuit 122 shown in FIG. 13 may be used with the configuration of the memory array enable circuit 120 shown in FIG. 3 and with the configuration 1200 of the write programable matrix 123 shown in FIG. 12 to implement an 8-entries by 16-bit memory (i.e., an 8 x 16 memory). In this embodiment, memory array enable circuit 120 is configurated to enable all 4 of the memory array circuits 101-104 to perform read operations, as discussed in further detail with respect to FIG. 3.

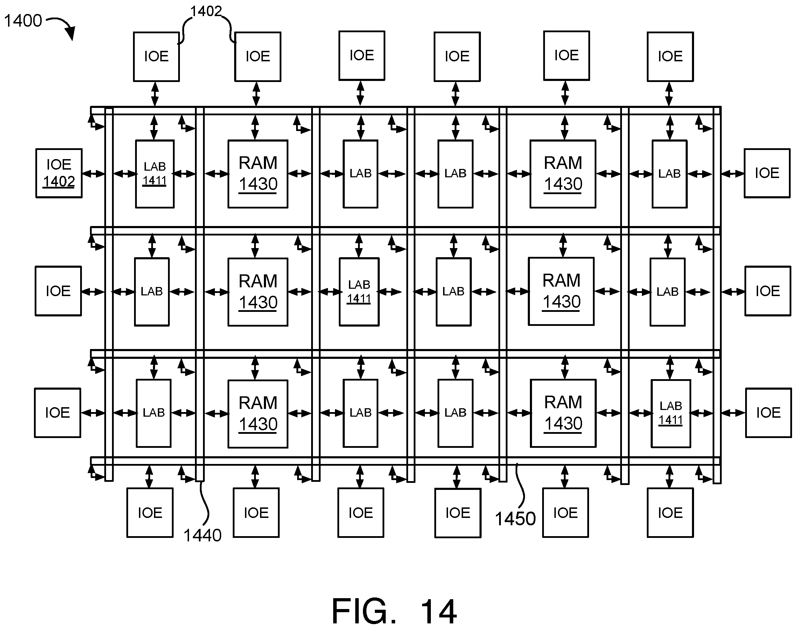

Figure 14 illustrates an exemplary embodiment of a structured application specific integrated circuit (ASIC) 1400 that may contain embodiments disclosed herein, for example, with respect to FIGS. 1-13 and 15. As shown in FIG. 14, ASIC 1400 includes a two-dimensional array of functional circuit blocks, including logic array blocks (LABs) 1411 and random access memory (RAM) blocks 1430. Functional blocks such as LABs 1411 may include smaller logic circuits.

In addition, structured ASIC 1400 has input/output elements (IOEs) 1402 for driving signals off the IC and for receiving signals from other devices. Each of the IOEs 1402 includes one or more input buffers, one or more output buffers, and one or more IO pads. Input/output elements 1402 may include parallel input/output circuitry, serial data transceiver circuitry, differential receiver and transmitter circuitry, or other circuitry used to connect one integrated circuit to another integrated circuit. As shown, input/output elements 1402 may be located around the periphery of the ASIC. If desired, ASIC 1400 may have input/output elements 1402 arranged in different ways. For example, input/output elements 1402 may form one or more columns, rows, or islands of input/output elements that may be located anywhere on the ASIC.

The structured ASIC 1400 also includes interconnect circuitry in the form of vertical routing channels 1440 (i.e., interconnects formed along a vertical axis of ASIC 1400) and horizontal routing channels 1450 (i.e., interconnects formed along a horizontal axis of ASIC 1400), each routing channel including at least one track to route at least one conductor (e.g., wire). Note that other routing topologies, besides the topology of the interconnect circuitry depicted in FIG. 14, may be used. For example, the routing topology may include wires that travel diagonally or that travel horizontally and vertically along different parts of their extent as well as wires that are perpendicular to the device plane in the case of three dimensional integrated circuits. The driver of a wire may be located at a different point than one end of a wire.

Furthermore, it should be understood that embodiments disclosed herein with respect to FIGS. 1-13 may be implemented in any integrated circuit or electronic system. If desired, the functional blocks of such an integrated circuit may be arranged in more levels or layers in which multiple functional blocks are interconnected to form still larger blocks. Other device arrangements may use functional blocks that are not arranged in rows and columns.

Structured ASIC 1400 also contains random access memory (RAM) blocks 1430. Each of the RAM blocks 1430 in ASIC 1400 may include one or more of the memory circuit blocks 100 shown in FIG. 1. Each of the memory circuit blocks 100 in one of the RAM blocks 1430 may be configured as disclosed herein with respect to FIGS. 1-13 and 15 to implement one or more of multiple different configurations of memory arrays 101-104.

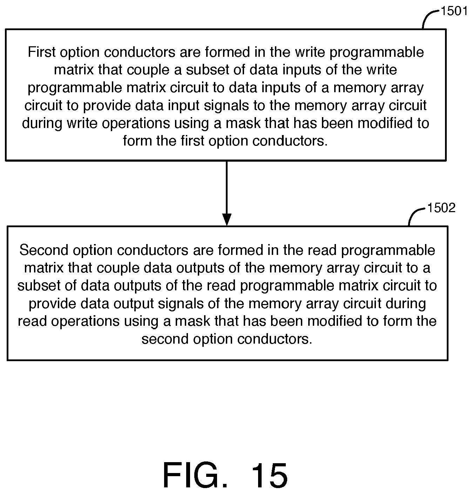

Figure 15 illustrates examples of operations that may be performed to form a memory circuit block 100 in an integrated circuit, according to an embodiment. In operation 1501, first option conductors are formed in a write programmable matrix circuit 123 that couple a subset of data inputs of the write programmable matrix circuit to data inputs of a memory array circuit to provide data input signals to the memory array circuit during write operations using a mask that has been modified to form the first option conductors. In operation 1502, second option conductors are formed in a read programmable matrix circuit 122 that couple data outputs of the memory array circuit to a subset of data outputs of the read programmable matrix circuit to provide data output signals of the memory array circuit during read operations using a mask that has been modified to form the second option conductors.

The following examples pertain to further embodiments. Example 1 is an integrated circuit comprising: a first memory array circuit; flip-flop circuits, wherein a first one of the flip-flop circuits is coupled to store one of a first write address signal or a first data input signal, and wherein a second one of the flip-flop circuits is coupled to store one of a second write address signal or a second data input signal; and a write programmable matrix circuit coupled to receive signals stored in the flip-flop circuits, wherein the write programmable matrix circuit is coupled to provide a first subset of the signals stored in the flip-flop circuits to inputs of the first memory array circuit through first option conductors in the write programmable matrix circuit during write operations to the first memory array circuit.

In Example 2, the integrated circuit of Example 1 can optionally further comprise: a read programmable matrix circuit coupled to provide data output signals from data outputs of the first memory array circuit to data outputs of the read programmable matrix circuit through second option conductors during read operations to the first memory array circuit.

In Example 3, the integrated circuit of any one of Examples 1-2 can optionally further comprise a memory array enable circuit comprising vias and a logic gate circuit, wherein the vias are filled with conductive material to couple first conductors at inputs of the logic gate circuit to second conductors to provide control signals to the inputs of the logic gate circuit to control enabling the first memory array circuit to perform the read and write operations.

In Example 4, the integrated circuit of any one of Examples 1-3 can optionally further comprise a second memory array circuit, wherein the write programmable matrix circuit is coupled to provide a second subset of the signals stored in the flip-flop circuits to inputs of the second memory array circuit through second option conductors in the write programmable matrix circuit during the write operations.

In Example 5, the integrated circuit of Example 4 can optionally further comprise a third memory array circuit, wherein the write programmable matrix circuit is coupled to provide a third subset of the signals stored in the flip-flop circuits to inputs of the third memory array circuit through programmable vias during the write operations.

In Example 6, the integrated circuit of any one of Examples 1-3 can optionally further comprise a second memory array circuit, wherein the write programmable matrix circuit is coupled to provide a second subset of the signals stored in the flip-flop circuits to inputs of the second memory array circuit through programmable vias during the write operations.

In Example 7, the integrated circuit of any one of Examples 1-3 or 6 can optionally include, wherein the write programmable matrix circuit is programmed during fabrication of the integrated circuit to change the first option conductors to couple first inputs of the write programmable matrix circuit to the inputs of the first memory array circuit by modifying a mask that is used to form the first option conductors, and wherein the write programmable matrix circuit is programmed during fabrication of the integrated circuit to change second option conductors to decouple second inputs of the write programmable matrix circuit from the inputs of the first memory array circuit by modifying a mask that is used to form the second option conductors.

In Example 8, the integrated circuit of any one of Examples 1-7 can optionally include, wherein the write programmable matrix circuit is programmed during fabrication of the integrated circuit to change programmable vias to couple inputs of the write programmable matrix circuit to the inputs of the first memory array circuit by filling the programmable vias with conductive material, and wherein the integrated circuit is a structured application specific integrated circuit.

Example 9 is an integrated circuit comprising: a first memory array circuit; a write programmable matrix circuit coupled to receive data input signals and to provide the data input signals to data inputs of the first memory array circuit through first option conductors in the write programmable matrix circuit during write operations to the first memory array circuit; and a read programmable matrix circuit coupled to provide first data output signals from data outputs of the first memory array circuit to a first subset of data outputs of the read programmable matrix circuit through second option conductors in the read programmable matrix circuit during read operations to the first memory array circuit.

In Example 10, the integrated circuit of Example 9 can optionally further comprise a second memory array circuit, wherein the read programmable matrix circuit is coupled to provide second data output signals from data outputs of the second memory array circuit to a second subset of the data outputs of the read programmable matrix circuit through third option conductors in the read programmable matrix circuit during the read operations.

In Example 11, the integrated circuit of any one of Examples 9-10 can optionally further comprise a second memory array circuit, wherein the read programmable matrix circuit is coupled to provide second data output signals from data outputs of the second memory array circuit to a second subset of the data outputs of the read programmable matrix circuit through programmable vias in the read programmable matrix circuit during the read operations.

In Example 12, the integrated circuit of any one of Examples 9-11 can optionally further comprise flip-flop circuits that store received signals, wherein the received signals are provided from the flip-flops circuits to the write programmable matrix circuit, wherein a first one of the flip-flop circuits is coupled to receive one of a first write address signal or a first one of the data input signals as a first one of the received signals, and wherein a second one of the flip-flop circuits is coupled to receive one of a second write address signal or a second one of the data input signals as a second one of the received signals.

In Example 13, the integrated circuit of any one of Examples 9-11 can optionally further comprise a first flip-flop circuit programmed during fabrication of the integrated circuit to provide one of a first write address signal or a first one of the data input signals to the write programmable matrix circuit; and a second flip-flop circuit programmed during fabrication of the integrated circuit to provide one of a second write address signal or a second one of the data input signals to the write programmable matrix circuit.

In Example 14, the integrated circuit of any one of Examples 9-13 can optionally include, wherein the read programmable matrix circuit is programmed during fabrication of the integrated circuit to change third option conductors to decouple the data outputs of the first memory array circuit from a second subset of the data outputs of the read programmable matrix circuit by changing a mask that is used to form the third option conductors.

In Example 15, the integrated circuit of any one of Examples 9-14 can optionally include, wherein the read programmable matrix circuit is programmed during fabrication of the integrated circuit to change programmable vias to couple the data outputs of the first memory array circuit to the first subset of the data outputs of the read programmable matrix circuit by filling the programmable vias with conductive material, and wherein the integrated circuit is a structured application specific integrated circuit.

Example 16 is a method for forming a memory circuit block in an integrated circuit, the method comprising: forming in the integrated circuit a write programmable matrix circuit by forming first option conductors that couple a first subset of data inputs of the write programmable matrix circuit to data inputs of a first memory array circuit to provide data input signals to the first memory array circuit during write operations using a mask that has been modified to form the first option conductors; and forming in the integrated circuit a read programmable matrix circuit by forming second option conductors that couple data outputs of the first memory array circuit to a first subset of data outputs of the read programmable matrix circuit to provide data output signals of the first memory array circuit during read operations using a mask that has been modified to form the second option conductors.

In Example 17, the method of Example 16 can optionally further comprise: forming in the integrated circuit a memory array enable circuit comprising a logic gate circuit and vias that are filled with conductive material to couple inputs of the logic gate circuit to receive control signals for enabling the first memory array circuit to perform the read and write operations.

In Example 18, the method of any one of Examples 16-17 can optionally include, wherein forming the write programmable matrix circuit further comprises forming third option conductors that couple a second subset of the data inputs of the write programmable matrix circuit to data inputs of a second memory array circuit using a mask that has been modified to form the third option conductors to provide additional data input signals to the second memory array circuit during the write operations.

In Example 19, the method of any one of Examples 16-17 can optionally include, wherein forming the write programmable matrix circuit further comprises forming the first option conductors to couple the first subset of the data inputs of the write programmable matrix circuit to data inputs of a second memory array circuit using the mask that has been modified to form the first option conductors.

In Example 20, the method of any one of Examples 16-17 can optionally include, wherein forming the read programmable matrix circuit further comprises forming third option conductors to couple data outputs of a second memory array circuit to a second subset of the data outputs of the read programmable matrix circuit using a mask that has been modified to form the third option conductors.

While the embodiments set forth in the present disclosure may be susceptible to various modifications and alternative forms, specific embodiments have been shown by way of example in the drawings and have been described in detail herein. However, it should be understood that the disclosure is not intended to be limited to the particular forms disclosed. The disclosure is intended to cover all modifications, equivalents, and alternatives falling within the spirit and scope of the disclosure as defined by the following appended claims. Moreover, the techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]... " or "step for [perform] ing [a function]... ", it is intended that such elements are to be interpreted under 35 U.S.C. 112(f). However, for any claims containing elements designated in any other manner, it is intended that such elements are not to be interpreted under 35 U.S.C. 112(f).

## Claims

1. An integrated circuit comprising:
a first memory array circuit;
flip-flop circuits, wherein a first one of the flip-flop circuits is coupled to store one of a first write address signal or a first data input signal, and wherein a second one of the flip-flop circuits is coupled to store one of a second write address signal or a second data input signal; and
a write programmable matrix circuit coupled to receive signals stored in the flip-flop circuits, wherein the write programmable matrix circuit is coupled to provide a first subset of the signals stored in the flip-flop circuits to inputs of the first memory array circuit through first option conductors in the write programmable matrix circuit during write operations to the first memory array circuit.

2. The integrated circuit of claim 1 further comprising:
a read programmable matrix circuit coupled to provide data output signals from data outputs of the first memory array circuit to data outputs of the read programmable matrix circuit through second option conductors during read operations to the first memory array circuit.

3. The integrated circuit of any one of claims 1 or 2 further comprising:
a memory array enable circuit comprising vias and a logic gate circuit, wherein the vias are filled with conductive material to couple first conductors at inputs of the logic gate circuit to second conductors to provide control signals to the inputs of the logic gate circuit to control enabling the first memory array circuit to perform the read and write operations.

4. The integrated circuit of any one of claims 1-3 further comprising:
a second memory array circuit, wherein the write programmable matrix circuit is coupled to provide a second subset of the signals stored in the flip-flop circuits to inputs of the second memory array circuit through second option conductors in the write programmable matrix circuit during the write operations.

5. The integrated circuit of claim 4 further comprising:
a third memory array circuit, wherein the write programmable matrix circuit is coupled to provide a third subset of the signals stored in the flip-flop circuits to inputs of the third memory array circuit through programmable vias during the write operations.

6. The integrated circuit of any one of claims 1-3 further comprising:
a second memory array circuit, wherein the write programmable matrix circuit is coupled to provide a second subset of the signals stored in the flip-flop circuits to inputs of the second memory array circuit through programmable vias during the write operations.

7. The integrated circuit of claim 1, wherein the write programmable matrix circuit is programmed during fabrication of the integrated circuit to change the first option conductors to couple first inputs of the write programmable matrix circuit to the inputs of the first memory array circuit by modifying a mask that is used to form the first option conductors, and wherein the write programmable matrix circuit is programmed during fabrication of the integrated circuit to change second option conductors to decouple second inputs of the write programmable matrix circuit from the inputs of the first memory array circuit by modifying a mask that is used to form the second option conductors.

8. The integrated circuit of any one of claims 1-7, wherein the write programmable matrix circuit is programmed during fabrication of the integrated circuit to change programmable vias to couple inputs of the write programmable matrix circuit to the inputs of the first memory array circuit by filling the programmable vias with conductive material, and wherein the integrated circuit is a structured application specific integrated circuit.

9. The integrated circuit of any one of claims 1-7, wherein the integrated circuit is a structured application specific integrated circuit.

10. A method for forming a memory circuit block in an integrated circuit, the method comprising:
forming in the integrated circuit a write programmable matrix circuit by forming first option conductors that couple a first subset of data inputs of the write programmable matrix circuit to data inputs of a first memory array circuit to provide data input signals to the first memory array circuit during write operations using a mask that has been modified to form the first option conductors; and
forming in the integrated circuit a read programmable matrix circuit by forming second option conductors that couple data outputs of the first memory array circuit to a first subset of data outputs of the read programmable matrix circuit to provide data output signals of the first memory array circuit during read operations using a mask that has been modified to form the second option conductors.

11. The method of claim 10 further comprising:
forming in the integrated circuit a memory array enable circuit comprising a logic gate circuit and vias that are filled with conductive material to couple inputs of the logic gate circuit to receive control signals for enabling the first memory array circuit to perform the read and write operations.

12. The method of any one of claims 10-11, wherein forming the write programmable matrix circuit further comprises forming third option conductors that couple a second subset of the data inputs of the write programmable matrix circuit to data inputs of a second memory array circuit using a mask that has been modified to form the third option conductors to provide additional data input signals to the second memory array circuit during the write operations.

13. The method of any one of claims 10-11, wherein forming the write programmable matrix circuit further comprises forming the first option conductors to couple the first subset of the data inputs of the write programmable matrix circuit to data inputs of a second memory array circuit using the mask that has been modified to form the first option conductors.

14. The method of any one of claims 10-11, wherein forming the read programmable matrix circuit further comprises forming third option conductors to couple data outputs of a second memory array circuit to a second subset of the data outputs of the read programmable matrix circuit using a mask that has been modified to form the third option conductors.

15. The method of any one of claims 10-14, wherein the integrated circuit is a structured application specific integrated circuit.
